# EUROPÄISCHE PATENTSCHRIFT

(11) **EP 2 819 309 B1**
(45) Veröffentlichungstag und Bekanntmachung des Hinweises auf die Patenterteilung: **12.02.2020**
(21) Anmeldenummer: 14168646.9
(22) Anmeldetag: 16.05.2014
(51) Int. Cl.: H03M 1/12, H03M 1/10, G06F 1/10

(54) **Optoelektronische Schaltung und Verfahren zur Übertragung eines optischen Taktsignals**
Optoelectronic circuit and method of transferring an optical clock signal
Circuit optoélectronique et procédé de transmission d'un signal de synchronisation optique

(30) Priorität: 28.06.2013 DE 102013212702
(43) Veröffentlichungstag der Anmeldung: 31.12.2014
(73) Patentinhaber: Rohde & Schwarz GmbH & Co. KG, 81671 München (DE)
(72) Erfinder: Kahmen, Gerhard, 82041 Oberhaching (DE); Dettmann, Ingo, 81539 München (DE)
(74) Vertreter: Körfer, Thomas

(56) Entgegenhaltungen:
- WO-A1-91/19243
- US-A1- 2011 057 091
- US-B1- 6 215 941
- US-B1- 7 646 984

## Beschreibung

Die Erfindung betrifft eine optoelektronische Schaltung und ein Verfahren, welche eine Feinjustierung von Signallaufzeiten in einem optischen Pfad ermöglichen.

Optische und optoelektronische Systeme weisen in der Regel komplexe Wellenleiterstrukturen auf, welche zum Transport eines optischen Signals verwendet werden. In zahlreichen Anwendungen ist eine auf wenige fs genau kontrollierbare Signallaufzeit erforderlich, um eine geforderte Performance des Gesamtsystems zu erreichen. So zeigt beispielsweise das US Patent US 7,956,788 B2 einen optoelektronischen Analog-Digital-Wandler, bei welchem einzelne Abtast-Halte-Glieder mit einem optischen Taktsignal gesteuert werden.

Die US 7,646,984 B1 zeigt eine optoelektronische Vorrichtung zur Erzeugung und Übertragung von Taktsignalen an elektronische Bauelemente. Dabei wird ein Taktsignal erzeugt und als optisches Signal über Lichtleiter zu den elektronischen Bauelementen verteilt. Vor jedem elektronischen Bauelement sitzt dabei ein Wandler, welcher das optische Taktsignal in ein elektronisches Taktsignal wandelt. Zusätzlich sind einstellbare optische Elemente vorhanden, welche in die optischen Pfade des Taktsignals geschaltet sind und dazu geeignet sind, die Laufzeiten der Taktsignale einzustellen.

Die WO 91/19243 A1 zeigt eine andere Art der Verteilung von Taktsignalen. Die WO 91/19243 A1 zeigt keine Kalibriereinrichtung und keine Durchführung von Kalibriermessungen mit Durchführung eines dedizierten Kalibriersignals. Insbesondere zeigt auch WO 91/19243 A1 keine Einstellung einzelner optischer Elemente basierend auf derartigen Kalibrierwerten.

Fertigungsbedingt treten sowohl im optischen Netzwerk wie auch in den elektronischen Komponenten Streuungen der Abtastzeitpunkte auf. Diese Streuungen werden z.B. durch Toleranzen in der geometrischen Fertigung der Wellenleiter, Toleranzen in den Brechungsindices der Wellenleiter aber auch durch Toleranzen in den elektronischen Komponenten verursacht. Hinzu kommen thermische Gradienten in der Schaltung, welche ortsabhängig zu Schwankungen in den Laufzeiten der optischen und elektronischen Komponenten führen.

Ein für die Performance des Gesamtsystems relevanter Wert ist die zeitliche Genauigkeit mit welcher das analoge Signal abgetastet wird. Insbesondere bei der Verwendung von N zeitlich verschachtelten Samplern, welche zusammen einen Sampler mit N-facher Abtastraste ergeben, ist eine exakte Abtastung zu dem Zeitpunkt t₀+(M/N) ^{∗} t_clock nötig. Dabei stellt M die Nummer des einzelnen Samplers im System dar. Kann eine zeitlich exakte Abtastung zwischen den Samplern nicht gewährleistet werden, so entstehen in dem aus den einzelnen Samplern rekonstruierten Signal unerwünschte Nebenlinien.

Es ergibt sich somit die Aufgabe, eine optoelektronische Schaltung und ein Verfahren zum Betrieb einer optoelektronischen Schaltung zu schaffen, welche eine sehr genaue Einhaltung der geplanten Laufzeiten der Signale ermöglichen.

Die Aufgabe wird erfindungsgemäß für die Vorrichtung durch die Merkmale des unabhängigen Anspruchs 1 und für das Verfahren durch die Merkmale des unabhängigen Anspruchs 10 gelöst. Vorteilhafte Weiterbildungen sind Gegenstand der hierauf rückbezogenen Unteransprüche.

Eine erfindungsgemäße optoelektronische Schaltung zur Übertragung eines optischen Taktsignals an ein elektronisches Bauelement beinhaltet eine Takterzeugungseinrichtung zur Erzeugung des optischen Taktsignals, ein Wandlerelement zur Umwandlung des optischen Taktsignals in ein dem elektronischen Bauelement zugeführtes elektrisches Taktsignal und eine optische Leitung von der Takterzeugungseinrichtung zu dem Wandlerelement. Die optoelektronische Schaltung weist dabei eine Laufzeit des optischen Taktsignals von der Takterzeugungseinrichtung zu dem Wandlerelement auf. Die optoelektronische Schaltung verfügt dabei über ein einstellbares optisches Element zur Einstellung der Laufzeit zwischen der Takterzeugungseinrichtung und dem elektronischen Bauelement. So können Ungenauigkeiten der Laufzeit auf Grund von Bauteiltoleranzen, thermischen Belastungen, etc. entstehen kompensiert werden.

Vorteilhafterweise ist die optischen Leitung das einstellbare optische Element. Die Laufzeit ist dann durch Veränderung einer optischen Länge der optischen Leitung einstellbar. Die optische Leitung weist dann zumindest ein Heizelement zur Beheizung der optischen Leitung auf. Die optische Länge der optischen Leitung ist zur Einstellung der Laufzeit durch Beheizung der optischen Leitung einstellbar. So kann die Laufzeit sehr einfach ohne weitere in den optischen Pfad geschaltete Komponenten eingestellt werden. Durch die Änderung der Temperatur kann weiterhin der Brechungsindex eingestellt werden. Hierdurch lässt sich die Laufzeit ebenfalls beeinflussen.

Alternativ weist die optoelektronische Schaltung in Serie zu der optischen Leitung geschaltet eine Kerr-Zelle oder eine Pockels-Zelle als einstellbares optisches Element auf. Die Laufzeit ist dann durch Einstellen der optischen Länge der Kerr-Zelle oder der Pockels-Zelle durch Anlegen eines elektrischen Signals an die Kerr-Zelle oder Pockels-Zelle einstellbar. So kann die Laufzeit besonders genau eingestellt werden. Außerdem kann so der Einsatz von Heizelementen vermieden werden, welche einen hohen Stromverbrauch aufweisen.

Bevorzugt ist die Takterzeugungseinrichtung eine mit der Taktfrequenz gepulste Lichtquelle, insbesondere ein gepulster Laser oder eine gepulste Laserdiode oder eine gepulste Diode. Das Wandlerelement ist bevorzugt eine Photodiode oder ein Phototransistor. Eine erfindungsgemäße optoelektronische Vorrichtung verfügt über zumindest zwei oben beschriebene optoelektronische Schaltungen, eine Regeleinrichtung zur Regelung der Laufzeiten der optoelektronischen Schaltungen und zumindest zwei elektronische Bauelemente. So können unterschiedliche Zeitpunkte des Eintreffens der Taktsignale an die zwei elektronischen Bauelemente realisiert werden.

Bevorzugt ist die optoelektronische Vorrichtung eine Abtastschaltung. Die optoelektronische Vorrichtung verfügt dann über Abtast-Halte-Glieder als die elektronischen Bauelemente, an welche die optoelektronischen Schaltungen das Taktsignal übertragen. Die Laufzeiten der optoelektronischen Schaltungen sind dabei derart dimensioniert, dass sich innerhalb einer Abtastperiode die unterschiedlichen Abtastzeitpunkte der Abtast-Halte-Glieder ergeben. Die Regelungseinrichtung ist dabei ausgebildet, um die Abtastzeitpunkte durch Einstellung der Laufzeiten der optoelektronischen Schaltungen zu justieren. So kann eine besonders hohe Genauigkeit der Abtastzeitpunkte erzielt werden.

Alternativ ist die optoelektronische Vorrichtung eine Multiplexerschaltung. Die optoelektronische Vorrichtung verfügt dann über Umschalt-Glieder als die elektronischen Bauelemente, an welche die optoelektronischen Schaltungen das Taktsignal übertragen. Die Laufzeiten der optoelektronischen Schaltungen sind dann derart dimensioniert, dass sich unterschiedliche Umschaltzeitpunkte der Umschalt-Glieder bei ganzzahligen Teilern jeder Taktperiode ergeben. Die Regelungseinrichtung ist dann ausgebildet, um die Umschaltzeitpunkte durch Einstellung der Laufzeiten der optoelektronischen Schaltungen zu justieren. So kann eine besonders genaue Einstellung der Umschaltzeitpunkte der einzelnen Umschaltglieder erreicht werden.

Bevorzugt ist die Regelungseinrichtung ausgebildet, um mittels der einstellbaren optischen Elemente einen Temperaturgradienten innerhalb der optoelektronischen Vorrichtung zu kompensieren. So können durch andere Bauteile verursachte Temperaturgradienten, welche die Laufzeiten beeinflussen, kompensiert werden.

Vorteilhafterweise weist die optoelektronische Vorrichtung weiterhin eine Kalibriereinrichtung zur Einspeisung eines Kalibriersignals auf. Die optoelektronische Vorrichtung ist dann ausgebildet, um im Rahmen einer Kalibriermessung Kalibrierwerte basierend auf dem eingespeisten Kalibriersignal zu bestimmen und um basierend auf den Kalibrierwerten die einstellbaren optischen Elemente einzustellen. So kann eine besonders hohe Genauigkeit der Justierung der Laufzeiten erzielt werden.

Ein erfindungsgemäßes Verfahren dient der Übertragung eines optischen Taktsignals an ein elektronisches Bauelement. Zunächst wird ein optisches Taktsignal erzeugt. Dieses wird vor der Zuführung zu dem elektronischen Bauelement in ein elektrisches Signal umgewandelt. Das optische Taktsignal wird dabei über eine optische Leitung an das elektronische Bauelement geführt. Das optische Taktsignal weist dabei eine Laufzeit von der Takterzeugung bis zu dem elektronischen Bauelement auf. Diese Laufzeit kann eingestellt werden. So können Ungenauigkeiten der Laufzeit auf Grund von Bauteiltoleranzen, thermischen Belastungen, etc. kompensiert werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: ein erstes Ausführungsbeispiel der erfindungsgemäßen optoelektronischen Schaltung in einer exemplarischen optoelektronischen Vorrichtung;
- Fig. 2: ein Detail eines zweiten Ausführungsbeispiels der erfindungsgemäßen optoelektronischen Schaltung;
- Fig. 3: ein Detail eines dritten Ausführungsbeispiels der erfindungsgemäßen optoelektronischen Schaltung im Betrieb;
- Fig. 4: ein viertes Ausführungsbeispiel der erfindungsgemäßen optoelektronischen Schaltung, und
- Fig. 5: ein Ausführungsbeispiel des erfindungsgemäßen Verfahrens.

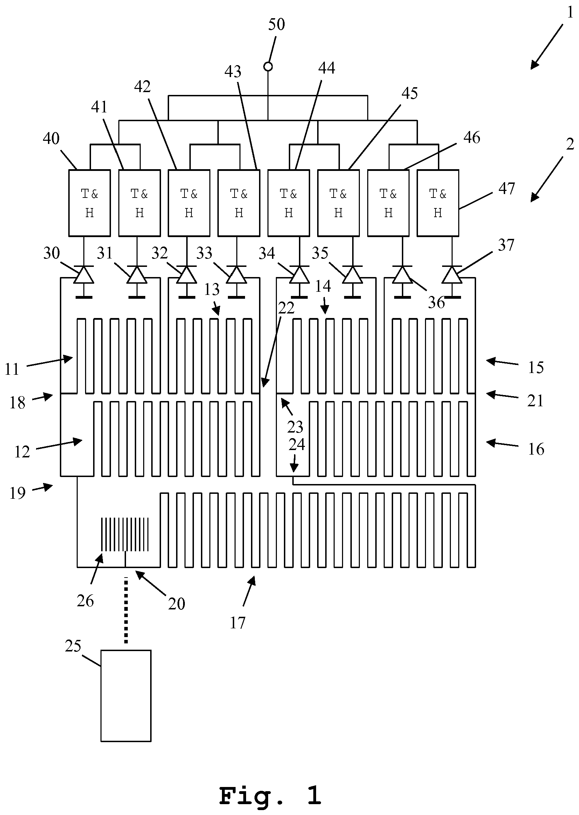

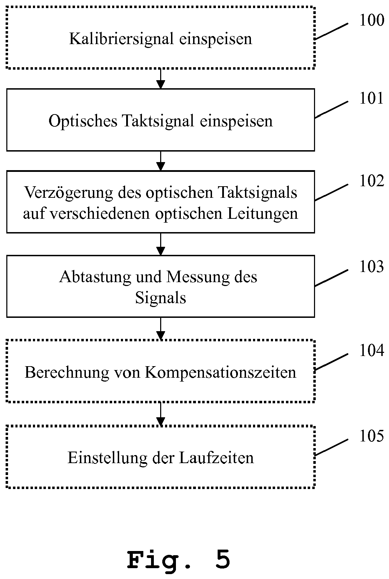

Zunächst wird anhand der Fig. 1 die der gegenwärtigen Erfindung zugrundeliegende Problematik detailliert beschrieben. Anschließend wird anhand von Fig. 1 - Fig. 4 der Aufbau und die Funktionsweise unterschiedlicher Ausführungsbeispiele der erfindungsgemäßen optoelektronischen Schaltung erläutert. Abschließend wird anhand von Fig. 5 auf die Funktionsweise eines Ausführungsbeispiels des erfindungsgemäßen Verfahrens eingegangen. Identische Elemente wurden in ähnlichen Abbildungen zum Teil nicht wiederholt dargestellt und beschrieben.

In Fig. 1 ist eine optoelektronische Vorrichtung 1 dargestellt. Bei der hier dargestellten optoelektronischen Vorrichtung 1 handelt es sich um eine Abtastschaltung, wie sie z.B. in einem Analog-Digital-Wandler eingesetzt wird. Die optoelektronische Vorrichtung 1 beinhaltet dabei einen Signalanschluss 50, über welchen ein abzutastendes Signal eingespeist werden kann. Mit dem Signalanschluss 50 verbunden ist eine Mehrzahl von Abtast-Halte-Gliedern 40-47, welchen jeweils das abzutastende Signal zugeführt ist. Weiterhin beinhaltet die optoelektronische Vorrichtung 1 eine Mehrzahl von optoelektronischen Schaltungen 2, welche eine jeweils ein Wandlerelement 30 - 37 beinhalten. Die Wandlerelemente 30 - 37 sind dabei hier als Photodioden ausgeführt. Diese sind jeweils mit einem der Abtast-Halte-Gliedern 40 - 47 der optoelektronischen Vorrichtung 1 verbunden und ausgebildet, um die Abtastung durch die Abtast-Halte-Glieder auszulösen, sobald ein optisches Signal das jeweilige Wandlerelement 30 - 37 erreicht.

Jede der optoelektronischen Schaltungen 2 verfügt weiterhin über eine optische Leitung mittels welcher sie mit einer Takterzeugungseinrichtung 25, welche hier durch einen Laser gebildet ist, verbunden ist. Die Länge von sich dabei ergebenden jeweiligen optischen Pfaden unterscheidet sich.

So wird eine unterschiedliche Laufzeit der Signale von der Takterzeugungseinrichtung 25 zu den einzelnen Wandlerelementen 30-37 erreicht. Die Laufzeit zwischen der Takterzeugungseinrichtung 25 und den Abtast-Halte-Gliedern 40-47 ist dabei derart eingestellt, dass sich eine Gleichverteilung der Abtastzeitpunkte der Abtast-Halte-Glieder 40-47 während einer Taktperiode des von der Takterzeugungseinrichtung 25 vorgegebenen Takts ergibt. So kann in diesem Beispiel mit einer gegenüber der Taktrate 8-fach höheren Abtastrate abgetastet werden.

Jede der optoelektronischen Schaltungen 2 verfügt dabei über ein eigenes Wandlerelement 30-37 und eine optische Leitung von der Takterzeugungseinrichtung 25 zu dem Wandlerelement 30-37. Darüber hinaus teilen sich die optoelektronischen Schaltungen 2 die gemeinsame Takterzeugungseinrichtung 25. Die Takterzeugungseinrichtung 25 ist somit hier Teil sämtlicher optoelektronischer Schaltungen 2.

Um das optische Taktsignal in die optischen Leitungen einzuspeisen, verfügt das hier dargestellte System darüber hinaus über einen Gitterkoppler 26, welcher auf die Wellenlänge der Takterzeugungseinrichtung 25 eingestellt ist und so eine möglichst große Leistung in die optischen Leitungen übernimmt. Von dem Gitterkoppler 26 wird das eingespeiste optische Taktsignal über einen Signalteiler 20 in einen linken Pfad und in einen rechten Pfad geteilt. Der linke Pfad wird erneut über einen Signalteiler 19 geteilt. Der linke Pfad des Signalteilers 19 wird einem weiteren Signalteiler 18 zugeführt. Der linke Pfad des Signalteilers 18 wird direkt zur Ansteuerung des Wandlerelements 30 herangezogen. Der rechte Pfad des Signalteilers 18 ist mit einem Verzögerungselement 11 verbunden, welches aus einer mäandernden optischen Leitung vorgegebene Länge besteht. Das Verzögerungselement 11 verzögert dabei das Taktsignal und leitet es an das Wandlerelement 31 weiter.

Der rechte Pfad des Signalteilers 19 ist über ein weiteres Verzögerungselement 12 mit einem weiteren Signalteiler 22 verbunden. Der rechte Pfad des Signalteilers 22 steuert direkt das Wandlerelement 33 an, während der linke Pfad des Signalteilers 22 über ein weiteres Verzögerungselement 13 das Wandlerelement 32 ansteuert. Der rechte Pfad des Signalteilers 20 führt zunächst über ein weiteres Verzögerungselement 17 und anschließend zu einem weiteren Signalteiler 24. Dessen linker Pfad führt zu einem weiteren Signalteiler 23, dessen linker Pfad direkt zur Ansteuerung des Wandlerelements 34 genutzt ist. Der rechte Pfad des Signalteilers 23 führt über ein weiteres Verzögerungselement 14 zu dem Wandlerelement 35. Der rechte Pfad des Signalteilers 24 führt über ein weiteres Verzögerungselement 16 zu einem weiteren Signalteiler 21. Dessen rechter Pfad steuert direkt das Wandlerelement 37 an, während dessen linker Pfad über ein weiteres Verzögerungselement 15 das Wandlerelement 36 ansteuert.

Es ergeben sich Fehler hinsichtlich der Laufzeiten der optischen Signale im Bereich von typischerweise 1 - 100 fs. Eine noch genauere Kalibrierung ohne Kompensation von Alterungserscheinungen, Bauteiltoleranzen und Temperaturänderungen ist nicht möglich. D.h. der oben genannte Fehler wird durch Anpassung der optischen Längen kompensiert.

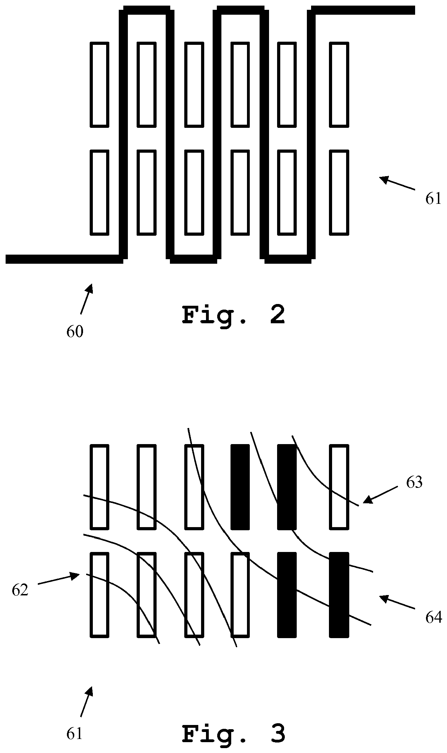

In dem hier dargestellten Ausführungsbeispiel sind keine gesonderten einstellbaren optischen Elemente zur Einstellung der Laufzeit zwischen der Takterzeugungseinrichtung 25 und dem jeweiligen Wandlerelement 30 - 37 eingezeichnet. Hier sind die Laufzeiten durch die Verzögerungselemente 11 - 17 direkt einstellbar. D.h. die Verzögerungselemente 11 - 17 entsprechen einstellbaren optischen Elementen zur Einstellung der Laufzeit. In Fig. 1 nicht dargestellt ist der Mechanismus zur Einstellung der Laufzeit der Verzögerungselemente 11 - 17. Hierauf wird näher anhand von Fig. 2 und Fig. 3 eingegangen.

Wie zuvor erläutert, ergeben sich aus verschiedenen Gründen Ungenauigkeiten hinsichtlich der Laufzeiten der Signale von einer Takterzeugungseinrichtung bis zu den elektronischen Bauelementen, welche zu exakt bestimmten Zeiten angesteuert werden sollen. So können einerseits Ungenauigkeiten der optischen Längen der optischen Pfade zwischen der Taktsignalerzeugung und den Wandlerelementen 30 - 37 bestehen. Andererseits können Ungenauigkeiten der elektrischen Längen zwischen den Wandlerelementen 30 - 37 und den elektronischen Bauelementen 40 - 47 bestehen. Um diese Ungenauigkeiten auszugleichen, können die Signallaufzeiten durch Anpassung der optischen Längen der optischen Pfade von der Takterzeugungseinrichtung 25 zu den einzelnen Wandlerelementen 30 - 37 justiert werden. D.h. nicht nur die optischen Ungenauigkeiten können kompensiert werden, sondern auch die elektronischen Ungenauigkeiten.

Für die Lichtgeschwindigkeit in Wellenleitern gilt C_{Medium}=c₀/n (T) . Dabei stellt c₀ die Lichtgeschwindigkeit im freien Raum dar, n(T) ist der temperaturabhängige Brechungsindex des Wellenleiters. Somit kann die Lichtgeschwindigkeit innerhalb des Wellenleiters durch Veränderung der Temperatur angepasst werden. Somit lässt sich die Laufzeit innerhalb des Wellenleiters durch Anpassung der Temperatur verändern.

In Fig. 2 ist ein Detail eines zweiten Ausführungsbeispiels der erfindungsgemäßen optoelektronischen Schaltung dargestellt. In Fig. 2 dargestellt, sind ein Wellenleiter 60 und eine Mehrzahl von Heizelementen 61. Die Heizelemente 61 sind dabei in der Umgebung des Wellenleiters 60 angeordnet und dazu ausgebildet, den Wellenleiter 60 zu beheizen. Die einzelnen Heizelemente 61 können dabei einzeln angesteuert werden, um einen Temperaturgradienten zu erzeugen. Dies ist insbesondere dann nützlich, wenn z.B. durch stark heizende Bauelemente in der übrigen Schaltung ein Temperaturgradient vorhanden ist. In diesem Fall kann ein Gegengradient durch die Heizelemente 61 erzeugt werden, um so eine möglichst homogene Temperaturverteilung und damit eine möglichst ausgeglichene Laufzeit zu erreichen. Dies wird anhand von Fig. 3 näher dargestellt. Durch Anpassung der Temperatur der Heizelemente 61 kann die Temperatur des Wellenleiters 60 verändert werden. Dadurch wird die optische Länge des Wellenleiters 60 verändert. Alternativ kann gezielt ein gewünschter Gradient erzeugt werden, um dadurch ein erwünschtes Laufzeitprofil zu erzeugen.

In Fig. 3 ist ein drittes Ausführungsbeispiel der erfindungsgemäßen optoelektronischen Schaltung in einem Detail im Betrieb dargestellt. Hier wurde auf die Darstellung des Wellenleiters 60 aus Fig. 2 verzichtet. Dargestellt sind hier die Mehrzahl von Heizelementen 61 und ein Temperaturgradient 62, welcher durch übrige auf der Schaltung vorhandene Komponenten erzeugt wird. Durch Ansteuerung eines Teils der Heizelemente 61, genauer durch die Ansteuerung der Heizelemente 64, gelingt es, einen Gegengradienten 63 zu erzeugen, welcher eine weitgehend homogene Temperaturverteilung ermöglicht.

Statt der Nutzung von Heizelementen, welche um die Wellenleiter angeordnet werden, kann alternativ auch in jeden optischen Pfad zu einem der Wandlerelemente 30 - 37 aus Fig. 1 ein gesondertes einstellbares optisches Element in Serie zu der optischen Leitung - dem Wellenleiter - geschaltet werden. Hierfür bieten sich beispielsweise Kerr-Zellen oder Pockels-Zellen an. Diese erlauben eine Anpassung der optischen Länge durch Anlegen eines elektrischen Signals. Auch andere Bauelemente, welche zur Veränderung ihrer optischen Länge angeregt werden können, können hier eingesetzt werden.

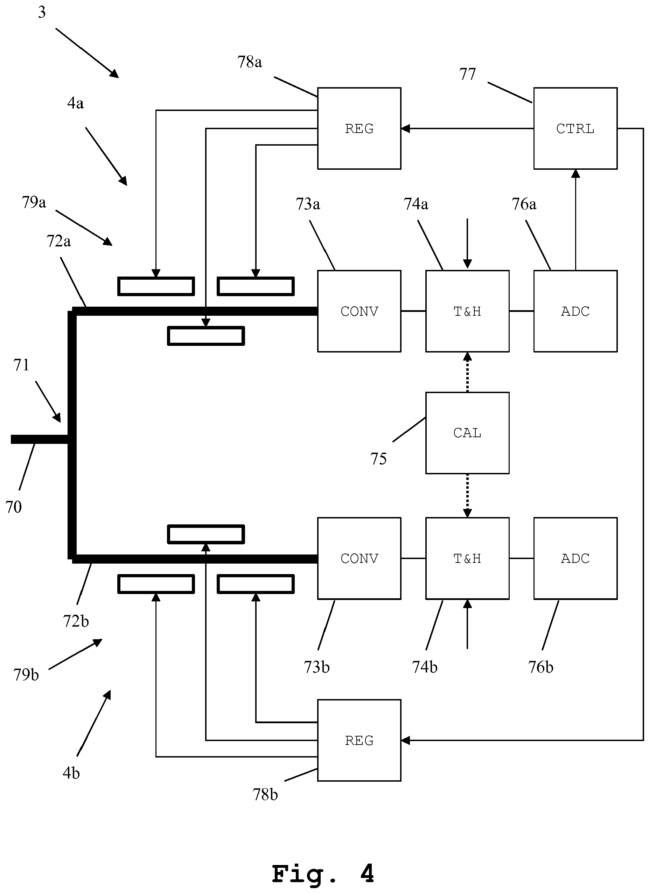

In Fig. 4 ist ein viertes Ausführungsbeispiel der optoelektronischen Schaltung in einer optoelektronischen Vorrichtung 3 gezeigt. Hier wird insbesondere auf die Ansteuerung der einstellbaren optischen Elemente - hier von über Heizelemente beheizbare Wellenleiter - eingegangen.

Die optoelektronische Vorrichtung 3 beinhaltet zwei optoelektronische Schaltungen 4a, 4b, und mit diesen verbunden, jeweils ein Abtast-Halte-Glied 74a bzw. 74b und mit diesen verbunden jeweils ein Analog-Digital-Wandler 76a, 76b. Darüber hinaus beinhaltet die optoelektronische Vorrichtung 3 eine Steuereinrichtung 77 und Regelungseinrichtungen 78a und 78b. Auf die Darstellung einer von der optoelektronischen Vorrichtung beinhalteten Takterzeugungseinrichtung wurde hier verzichtet.

Eine optische Leitung 70 wird zum Einspeisen eines optischen Taktsignals genutzt. Über einen Signalteiler 71 wird das optische Taktsignal auf eine erste optoelektronische Schaltung 4a und eine zweite optoelektronische Schaltung 4b aufgeteilt. Die optoelektronischen Schaltungen 4a, 4b beinhalten dabei eine optische Leitung 72a bzw. 72b und darum herum angeordnet Heizelemente 79a bzw. 79b.

Das optische Taktsignal wird von dem Signalteiler 71 an die beiden optischen Leitungen 72a bzw. 72b übertragen und von diesen optisch an Wandlerelemente 73a bzw. 73b übertragen. Die Wandlerelemente 73a bzw. 73b wandeln die optischen Signale in elektrische Signale um. Bei den Wandlerelementen 73a bzw. 73b handelt es sich beispielsweise um Photodioden oder Phototransistoren. Ein resultierendes elektrisches Taktsignal wird jeweils an die Abtast-Halte-Glieder 74a bzw. 74b übertragen. Den Abtast-Halte-Gliedern wird weiterhin das abzutastende Signal zugeführt. Resultierende Abtastwerte der Abtast-Halte-Glieder 74a bzw. 74b werden den Analog-Digital-Wandlern 76a, 76b zugeführt. Signalausgänge der Analog-Digital-Wandler 76a, 76b sind hier der Übersichtlichkeit halber nicht dargestellt.

Wird die optoelektronische Vorrichtung 3 mit einem unbekannten abzutastenden Signal beaufschlagt, so ist es nicht möglich, festzustellen, ob die Laufzeiten der Signale durch die optoelektronischen Schaltungen 4a, 4b korrekt sind. Um dies zu erreichen, wird eine Kalibrierung durchgeführt. Um eine Kalibrierung durchzuführen, beinhaltet die optoelektronische Vorrichtung 3 eine Kalibriereinrichtung 75, welche mit den Abtast-Halte-Gliedern 74a bzw. 74b verbunden ist. Die Kalibriereinrichtung 75 erzeugt dabei ein Kalibriersignal, z.B. ein hochgenaues bekanntes Sinussignal, welches statt des Nutzsignals an die Abtast-Halte-Glieder 74a, 74b übertragen wird. Das optische Taktsignal wird wie zuvor beschrieben durch die optischen Leitungen 72a, 72b zu den Wandlerelementen 73a, 73b übertragen und von diesen in ein elektrisches Taktsignal umgewandelt. Es erfolgt somit eine Messung des Kalibriersignals der Kalibriereinrichtung 75 mittels einer Abtastung durch die Abtast-Halte-Glieder und mittels der Analog-Digital-Wandler 76a, 76b.

Das resultierende Signal wird an die mit dem Analog-Digital-Wandler verbundene Steuereinrichtung 77 übertragen und von dieser ausgewertet. Es wird verglichen mit dem idealen Kalibriersignal, welches von der Kalibriereinrichtung 75 erzeugt wurde. Auf eine Darstellung der Verbindung zwischen der Kalibriereinrichtung 75 und der Steuereinrichtung 77 wurde hier aus Gründen der Übersichtlichkeit verzichtet. Die Steuereinrichtung 77 ermittelt somit basierend auf dem idealen Kalibriersignal und dem gemessenen Kalibriersignal, ob die Laufzeiten korrekt eingestellt sind. Ist dies nicht der Fall, so überträgt die Steuereinrichtung 77 an die damit verbundenen Regeleinrichtungen 78a bzw. 78b ein Signal, welches eine entsprechende Einstellung der Heizeinrichtungen 79a bzw. 79b auslöst.

Eine solche Kalibriermessung wird dabei so oft wiederholt, bis sich die gewünschten Laufzeiten auf den einzelnen optischen Pfaden einstellen. Sobald die Kalibrierung beendet ist, kann wieder mit der Messung des Nutzsignals fortgefahren werden. Ein derartiger Kalibriervorgang kann automatisch bei Aktivierung des Geräts durchgeführt werden. Alternativ kann ein Nutzer des Geräts ebenfalls einen solchen Kalibriervorgang initiieren.

Der Kalibriervorgang ist selbstverständlich auch mit der oben dargestellten Einstellung der Laufzeiten mittels Kerr-Zellen oder Pockels-Zellen kompatibel. In diesem Fall steuern die Regeleinrichtungen 78a bzw. 78b die Kerr-Zellen bzw. Pockels-Zellen an. Selbstverständlich ist das in Fig. 4 dargestellte Ausführungsbeispiel auch analog für eine größere Anzahl von optischen Pfaden erweiterbar.

Neben der aktiven Regelung mit einer Vermessung eines Kalibriersignals können zusätzlich im Rahmen einer Werkskalibrierung verschiedene Betriebszustände vermessen werden. Daraus resultierende Einstellungen der z.B. Heizelemente oder Kerr-Zellen oder Pockels-Zellen werden dann in einer Look-up-table abgespeichert und im Praxisfall beim jeweiligen Betriebszustand abgerufen.

Alternativ ist weiterhin eine direkte Messung der Temperatur an verschiedenen Stellen der Schaltung möglich. Diese gemessenen Temperaturen können dann durch gezielte Beheizung der Heizelemente oder durch Einstellung der Pockels-Zellen oder der Kerr-Zellen kompensiert werden. D. h. es erfolgt eine Echtzeit-Messung der Temperatur auf der Schaltung.

In Fig. 4 ist hier eine individuelle Ansteuerung der Heizelemente 79a, 79b durch die Regeleinrichtungen 78a, 78b dargestellt. Alternativ ist auch eine Zusammenfassung von zumindest zwei einzelnen Heizelementen zu gemeinsam angesteuerten Gruppen möglich. Mit dieser Maßnahme kann der Schaltungsaufwand reduziert werden.

Statt Heizelementen können Kühlelemente eingesetzt werden, um die optische Länge zu modifizieren. Anstatt mit diskreten Heizelementen, welche in der Schaltung verteilt sind, zu arbeiten, kann alternativ z.B. mittels Infrarotstrahlung berührungslos Wärme an bestimmte Stellen der Schaltung eingebracht werden. In den obigen Ausführungsbeispielen wurden die Begriffe optische Leitung und Wellenleiter synonym gebraucht.

Abschließend wird anhand von Fig. 5 auf die Funktionsweise eines Ausführungsbeispiels des erfindungsgemäßen Verfahrens eingegangen. In einem optionalen ersten Schritt 100 wird ein Kalibriersignal, d.h. ein hochgenaues und bekanntes Signal anstatt eines Nutzsignals eingespeist. In einem zweiten Schritt 101 wird ein optisches Taktsignal eingespeist. In einem dritten Schritt 102 wird das optische Taktsignal auf verschiedenen optischen Leitungen verzögert, um so gewünschte Laufzeiten des optischen Taktsignals zu erreichen. In einem vierten Schritt 103 erfolgt eine durch das optische Taktsignal ausgelöste Abtastung und Messung des Signals. Wurde der optionale Schritt 100 durchgeführt, so wird beim Schritt 103 das Kalibriersignal vermessen. Ansonsten wird ein Nutzsignal vermessen.

In einem weiteren optionalen Schritt 104 werden basierend auf dem bekannten Kalibriersignal und dem gemessenen Kalibriersignal Kompensationszeiten berechnet, welche notwendig sind, um die gewünschten Laufzeiten zu errechnen. In einem optionalen sechsten Schritt 105 werden die Laufzeiten basierend auf den berechneten Kompensationszeiten eingestellt. Die Einstellung der Laufzeiten erfolgt dabei z.B. durch Einstellung von Heizelementen, welche die optische Länge der optischen Leitungen verändern. Alternativ sind die anhand der Vorrichtung erläuterten Kerr-Zellen oder Pockels-Zellen ebenfalls einsetzbar.

Die Schritte 100, 104 und 105 sind dabei optional und gemeinsam durchzuführen. D.h. es werden entweder lediglich die Schritte 101 bis 103 für die Vermessung eines Nutzsignals ausgeführt oder die Schritte 100 bis 105, um eine Kalibrierung durchzuführen.

Die Erfindung ist nicht auf das dargestellte Ausführungsbeispiel beschränkt. Wie bereits erwähnt, können unterschiedliche Schaltungsfunktionen, wie z.B. eine Abtastschaltung oder eine Multiplexerschaltung eingesetzt werden. Sämtliche Schaltungen, welche einen optischen Taktbaum aufweisen, können erfindungsgemäß eingesetzt werden, indem die Laufzeiten optimiert werden. Alle vorstehend beschriebenen Merkmale oder in den Figuren gezeigten Merkmale sind im Rahmen der Erfindung beliebig vorteilhaft miteinander kombinierbar.

## Patentansprüche

1. Optoelektronische Vorrichtung mit zumindest zwei optoelektronischen Schaltungen (2, 4a, 4b), einer Regeleinrichtung (78a, 78b) zur Regelung der Laufzeiten der optoelektronischen Schaltungen, einer Takterzeugungseinrichtung (25) zur Erzeugung eines optischen Taktsignals, und zumindest zwei elektronischen Bauelementen (40-47, 74a, 74b),
wobei die zumindest zwei optoelektronischen Schaltungen jeweils zur Übertragung des optischen Taktsignals an jeweils eines der elektronischen Bauelemente (40-47, 74a, 74b) ausgebildet sind,
wobei die zumindest zwei optoelektronischen Schaltungen jeweils über:
- ein Wandlerelement (30-37, 73a, 73b) zur Umwandlung des optischen Taktsignals in das dem elektronischen Bauelement (40-47, 74a, 74b) zugeführtes elektrisches Taktsignal,
- eine optische Leitung (60, 72a, 72b) von der Takterzeugungseinrichtung (25) zu dem Wandlerelement (30-37, 73a, 73b), wobei die optische Leitung (60, 72a, 72b) jeweils ein einstellbares optisches Element zur Einstellung einer Laufzeit zwischen der Takterzeugungseinrichtung (25) und dem elektronischen Bauelement (40-47, 74a, 74b) ist, verfügen,
**dadurch gekennzeichnet,**
**dass** die optoelektronische Vorrichtung (1, 3) über Abtast-Halte-Glieder als die elektronischen Bauelemente (40-47, 74a, 74b) verfügt, und
**dass** die optoelektronische Vorrichtung (3) weiterhin eine Kalibriereinrichtung (75) zur Einspeisung eines Kalibriersignals aufweist, welche mit den Abtast-Halte-Gliedern verbunden ist, und
**dass** die optoelektronische Vorrichtung (3) ausgebildet ist, um im Rahmen einer Kalibriermessung Kalibrierwerte basierend auf dem eingespeisten Kalibriersignal zu bestimmen und um basierend auf den Kalibrierwerten die einstellbaren optischen Elemente (72a, 72b) einzustellen.

2. Optoelektronische Vorrichtung nach Anspruch 1,
**dadurch gekennzeichnet,**
**dass** die Laufzeit durch Veränderung einer optischen Länge der optischen Leitung (60, 72a, 72b) einstellbar ist,
**dass** die optische Leitung (60, 72a, 72b) jeweils zumindest ein Heizelement (61, 79a, 79b) zur Beheizung der optischen Leitung (60, 72a, 72b) aufweist, und
**dass** die optische Länge der optischen Leitung (60, 72a, 72b) zur Einstellung der Laufzeit jeweils durch Beheizung der optischen Leitung (60, 72a, 72b) einstellbar ist.

3. Optoelektronische Vorrichtung nach Anspruch 1,
**dadurch gekennzeichnet,**
**dass** die optoelektronischen Schaltungen (2, 4a, 4b) jeweils in Serie zu der optischen Leitung (60, 72a, 72b) geschaltet eine Kerr-Zelle oder eine Pockels-Zelle als einstellbares optisches Element aufweist, und
**dass** die Laufzeit jeweils durch Einstellen der optischen Länge der Kerr-Zelle oder der Pockels-Zelle durch Anlegen eines elektrischen Signals an die Kerr-Zelle oder Pockels-Zelle einstellbar ist.

4. Optoelektronische Vorrichtung nach einem der Ansprüche 1 bis 3,
**dadurch gekennzeichnet,**
**dass** die Takterzeugungseinrichtung (25) eine mit der Taktfrequenz gepulste Lichtquelle, insbesondere ein gepulster Laser oder eine gepulste Laserdiode oder eine gepulste Diode ist, und/oder
**dass** das Wandlerelement (30-37, 73a, 73b) jeweils eine Photodiode oder ein Phototransistor ist.

5. Optoelektronische Vorrichtung nach einem der Ansprüche 1 bis 4,
**dadurch gekennzeichnet,**
**dass** die optoelektronische Vorrichtung (1, 3) eine Abtastschaltung ist,
**dass** die Laufzeiten der optoelektronische Schaltungen (2, 4a, 4b) derart dimensioniert sind, dass sich unterschiedliche Abtastzeitpunkte der Abtast-Halte-Glieder (40-47, 74a, 74b) bei ganzzahligen Teilern jeder Taktperiode ergeben, und
**dass** die Regelungseinrichtung (78a, 78b) ausgebildet ist, um die Abtastzeitpunkte durch Einstellung der Laufzeiten der optoelektronischen Schaltungen (2, 4a, 4b) zu justieren.

6. Optoelektronische Vorrichtung nach einem der Ansprüche 1 bis 5,
**dadurch gekennzeichnet,**
**dass** die optoelektronische Vorrichtung eine Multiplexerschaltung ist,
**dass** die optoelektronische Vorrichtung über Umschalt-Glieder als die elektronischen Bauelemente, an welche die optoelektronischen Schaltungen (2, 4a, 4b) das Taktsignal übertragen, verfügt,
**dass** die Laufzeiten der optoelektronischen Schaltungen (2, 4a, 4b) derart dimensioniert sind, dass sich unterschiedliche Umschaltzeitpunkte der Umschalt-Glieder bei ganzzahligen Teilern jeder Taktperiode ergeben, und dass die Regelungseinrichtung (78a, 78b) ausgebildet ist, um die Umschaltzeitpunkte durch Einstellung der Laufzeiten der optoelektronischen Schaltungen (2, 4a, 4b) zu justieren.

7. Optoelektronische Vorrichtung nach einem der Ansprüche 1 bis 6,
**dadurch gekennzeichnet,**
**dass** die Regelungseinrichtung (78a, 78b) ausgebildet ist, um mittels der einstellbaren optischen Elemente einen Temperaturgradienten (62) innerhalb der optoelektronischen Vorrichtung zu kompensieren.

8. Verfahren zur Übertragung eines optischen Taktsignals an ein elektronisches Bauelement (40-47, 74a, 74bmit den folgenden Schritten:
- Erzeugung des optischen Taktsignals,
- Umwandlung des optischen Taktsignals in ein dem elektronischen Bauelement (40-47, 74a, 74b) zugeführtes elektrisches Taktsignal, und
- Zuführung des optischen Taktsignals über eine optische Leitung (60, 72a, 72b) zu der Umwandlung in das elektrische Taktsignal,
wobei das Taktsignal eine Laufzeit von der Takterzeugung bis zu dem elektronischen Bauelement (40-47, 74a, 74b) aufweist,
wobei die Laufzeit eingestellt und geregelt wird,
**dadurch gekennzeichnet,**
**dass** die elektronischen Bauelemente (40-47, 74a, 74b), an welche das Taktsignal übertragen wird, Abtast-Halte-Glieder sind, und
**dass** im Rahmen einer Kalibriermessung Kalibrierwerte basierend auf einem in die Abtast-Halte-Glieder eingespeisten Kalibriersignal bestimmt werden, und
**dass** basierend auf den Kalibrierwerten die Laufzeiten eingestellt werden.

9. Verfahren nach Anspruch 8,
**dadurch gekennzeichnet,**
**dass** die Laufzeit durch Veränderung einer optischen Länge einer optischen Leitung (60, 72a, 72b) eingestellt wird, dass die optische Länge der optischen Leitung (60, 72a, 72b) zur Einstellung der Laufzeit durch Beheizung der optischen Leitung (60, 72a, 72b) eingestellt wird.

10. Verfahren nach Anspruch 9,
**dadurch gekennzeichnet,**
**dass** die Laufzeit durch Einstellen der optischen Länge einer Kerr-Zelle oder einer Pockels-Zelle, welche in Serie zu einer optischen Leitung geschaltet ist, durch Anlegen eines elektrischen Signals an die Kerr-Zelle oder Pockels-Zelle eingestellt wird.

11. Verfahren nach einem der Ansprüche 8 bis 10,
**dadurch gekennzeichnet,**
**dass** das Verfahren der Übertragung eines Taktsignals in einer Abtastschaltung dient,
**dass** die Laufzeiten derart dimensioniert werden, dass sich unterschiedliche Abtastzeitpunkte der Abtast-Halte-Glieder (40-47, 74a, 74b) bei ganzzahligen Teilern jeder Taktperiode ergeben, und
**dass** die Abtastzeitpunkte durch Einstellung der Laufzeiten der optoelektronischen Schaltungen (2, 4a, 4b) justiert werden.

12. Verfahren nach einem der Ansprüche 8 bis 11,
**dadurch gekennzeichnet,**
**dass** das Verfahren der Übertragung eines Taktsignals in einer Multiplexerschaltung dient,
**dass** die elektronischen Bauelemente, an welche das Taktsignal übertragen wird, Umschalt-Glieder sind,
**dass** die Laufzeiten derart dimensioniert werden, dass sich unterschiedliche Umschaltzeitpunkte der Umschalt-Glieder bei ganzzahligen Teilern jeder Taktperiode ergeben, und dass die Umschaltzeitpunkte durch Einstellung der Laufzeiten justiert werden.

13. Verfahren nach einem der Ansprüche 8 bis 12,
**dadurch gekennzeichnet,**
**dass** ein Temperaturgradient (62) kompensiert wird.

## Claims

1. Optoelectronic apparatus having at least two optoelectronic circuits (2, 4a, 4b), an automatic control device (78a, 78b) for automatically controlling the delays of the optoelectronic circuits, a clock generation device (25) for generating an optical clock signal, and at least
two electronic components (40-47, 74a, 74b), wherein the at least two optoelectronic circuits are each designed to transmit the optical clock signal to each of the electronic components (40-47, 74a, 74b),
wherein the at least two optoelectronic circuits each have:
- a transducer element (30-37, 73a, 73b) for converting the optical clock signal into the electrical clock signal supplied to the electronic component (40-47, 74a, 74b),
- an optical line (60, 72a, 72b) from the clock generation device (25) to the transducer element (30-37, 73a, 73b), wherein each optical line (60, 72a, 72b) is an adjustable optical element for adjusting a delay between the clock generation device (25) and the electronic component (40-47, 74a, 74b),
**characterized**
**in that** the optoelectronic apparatus (1, 3) has sample-and-hold elements as the electronic components (40-47, 74a, 74b), and
**in that** the optoelectronic apparatus (3) furthermore has a calibration device (75) for supplying a calibration signal, which calibration device is connected to the sample-and-hold elements, and
**in that** the optoelectronic apparatus (3) is designed to determine calibration values on the basis of the supplied calibration signal as part of a calibration measurement and to take the calibration values as a basis for adjusting the adjustable optical elements (72a, 72b).

2. Optoelectronic apparatus according to claim 1,
**characterized**
**in that** the delay is adjustable by altering an optical length of the optical line (60, 72a, 72b), in that each optical line (60, 72a, 72b) has at least one heating element (61, 79a, 79b) for heating the optical line (60, 72a, 72b), and
**in that** the optical length of each optical line (60, 72a, 72b) is adjustable, to adjust the delay, by heating the optical line (60, 72a, 72b).

3. Optoelectronic apparatus according to claim 1,
**characterized**
**in that** the optoelectronic circuits (2, 4a, 4b) each have a Kerr cell or a Pockels cell connected in series with the optical line (60, 72a, 72b) as an adjustable optical element, and
**in that** the delay is adjustable in each case by adjusting the optical length of the Kerr cell or of the Pockels cell by applying an electrical signal to the Kerr cell or Pockels cell.

4. Optoelectronic apparatus according to one of claims 1 to 3,
**characterized**
**in that** the clock generation device (25) is a light source pulsed at the clock frequency, in particular a pulsed laser or a pulsed laser diode or a pulsed diode, and/or
**in that** each transducer element (30-37, 73a, 73b) is a photodiode or a phototransistor.

5. Optoelectronic apparatus according to one of claims 1 to 4,
**characterized**
**in that** the optoelectronic apparatus (1, 3) is a sampling circuit,
**in that** the delays of the optoelectronic circuits (2, 4a, 4b) are dimensioned such that different sampling times for the sample-and-hold elements (40-47, 74a, 74b) are obtained for integer factors of each clock period, and
**in that** the automatic control device (78a, 78b) is designed to align the sampling times by adjusting the delays of the optoelectronic circuits (2, 4a, 4b) .

6. Optoelectronic apparatus according to one of claims 1 to 5,
**characterized**
**in that** the optoelectronic apparatus is a multiplexer circuit,
**in that** the optoelectronic apparatus has changeover elements as the electronic components to which the optoelectronic circuits (2, 4a, 4b) transmit the clock signal,
**in that** the delays of the optoelectronic circuits (2, 4a, 4b) are dimensioned such that different changeover times for the changeover elements are obtained for integer factors of each clock period, and
**in that** the automatic control device (78a, 78b) is designed to align the changeover times by adjusting the delays of the optoelectronic circuits (2, 4a, 4b).

7. Optoelectronic apparatus according to one of claims 1 to 6,
**characterized**
**in that** the automatic control device (78a, 78b) is designed to use the adjustable optical elements to compensate for a temperature gradient (62) within the optoelectronic apparatus.

8. Method for transmitting an optical clock signal to an electronic component (40-47, 74a, 74b), having the following steps:
- generating the optical clock signal,
- converting the optical clock signal into an electrical clock signal supplied to the electronic component (40-47, 74a, 74b), and
- supplying the optical clock signal via an optical line (60, 72a, 72b) for the conversion into the electrical clock signal,
wherein the clock signal has a delay from the clock generation to the electronic component (40-47, 74a, 74b),
wherein the delay is adjusted and automatically controlled,
**characterized**
**in that** the electronic components (40-47, 74a, 74b) to which the clock signal is transmitted are sample-and-hold elements, and
**in that** as part of a calibration measurement calibration values are determined on the basis of a calibration signal supplied to the sample-and-hold elements and
**in that** the calibration values are taken as a basis for adjusting the delays.

9. Method according to claim 8,
**characterized**
**in that** the delay is adjusted by altering an optical length of an optical line (60, 72a, 72b), in that the optical length of the optical line (60, 72a, 72b) is adjusted, to adjust the delay, by heating the optical line (60, 72a, 72b).

10. Method according to claim 9,
**characterized**
**in that** the delay is adjusted by adjusting the optical length of a Kerr cell or a Pockels cell connected in series with an optical line by applying an electrical signal to the Kerr cell or Pockels cell.

11. Method according to one of claims 8 to 10,
**characterized**
**in that** the method is used for transmitting a clock signal in a sampling circuit,
**in that** the delays are dimensioned such that different sampling times for the sample-and-hold elements (40-47, 74a, 74b) are obtained for integer factors of each clock period, and
**in that** the sampling times are aligned by adjusting the delays of the optoelectronic circuits (2, 4a, 4b).

12. Method according to one of claims 8 to 11,
**characterized**
**in that** the method is used for transmitting a clock signal in a multiplexer circuit,
**in that** the electronic components to which the clock signal is transmitted are changeover elements,
**in that** the delays are dimensioned such that different changeover times for the changeover elements are obtained for integer factors of each clock period, and
**in that** the changeover times are aligned by adjusting the delays.

13. Method according to one of claims 8 to 12,
**characterized**
**in that** a temperature gradient (62) is compensated for.

## Revendications

1. Dispositif optoélectronique avec au moins deux circuits optoélectroniques (2, 4a, 4b), un équipement de régulation (78a, 78b) pour réguler les durées d'exécution des circuits optoélectroniques, un équipement de génération d'horloge (25) pour générer un signal d'horloge optique, et au moins deux composants électroniques (40-47, 74a, 74b),
dans lequel les au moins deux circuits optoélectroniques sont respectivement conçus pour transmettre le signal d'horloge optique à respectivement l'un des composants électroniques (40-47, 74a, 74b),
dans lequel les au moins deux circuits optoélectroniques disposent respectivement de :
- un élément de conversion (30-37, 73a, 73b) pour convertir le signal d'horloge optique en le signal d'horloge électrique amené au composant électronique (40-47, 74a, 74b),
- une liaison optique (60, 72a, 72b) allant de l'équipement de génération d'horloge (25) à l'élément de conversion (30-37, 73a, 73b), dans lequel la liaison optique (60, 72a, 72b) est respectivement un élément optique réglable pour régler une durée d'exécution entre l'équipement de génération d'horloge (25) et le composant électronique (40-47, 74a, 74b),
**caractérisé en ce que**
le dispositif optoélectronique (1, 3) dispose d'organes échantillonneurs-bloqueurs sous la forme des composants électroniques (40-47, 74a, 74b), et
le dispositif optoélectronique (3) présente en outre un équipement de calibrage (75) pour introduire un signal de calibrage, lequel équipement est relié aux organes échantillonneurs-bloqueurs, et
le dispositif optoélectronique (3) est conçu pour, dans le cadre d'une mesure de calibrage, déterminer des valeurs de calibrage sur la base du signal de calibrage introduit et pour régler les éléments optiques (72a, 72b) réglables sur la base des valeurs de calibrage.

2. Dispositif optoélectronique selon la revendication 1,
**caractérisé en ce que**
la durée d'exécution peut être réglée par modification d'une longueur optique de la liaison optique (60, 72a, 72b),
la liaison optique (60, 72a, 72b) présente respectivement au moins un élément de chauffage (61, 79a, 79b) pour chauffer la liaison optique (60, 72a, 72b), et
la longueur optique de la liaison optique (60, 72a, 72b) peut être réglée pour le réglage de la durée d'exécution respectivement par chauffage de la liaison optique (60, 72a, 72b).

3. Dispositif optoélectronique selon la revendication 1,
**caractérisé en ce que**
les circuits optoélectroniques (2, 4a, 4b) présente respectivement connectée en série par rapport à la liaison optique (60, 72a, 72b) une cellule de Kerr ou une cellule de Pockels en tant qu'élément optique réglable, et
la durée d'exécution peut être respectivement réglée par réglage de la longueur optique de la cellule de Kerr ou de la cellule de Pockels par application d'un signal électrique à la cellule de Kerr ou à la cellule de Pockels.

4. Dispositif optoélectronique selon l'une des revendications 1 à 3,
**caractérisé en ce que**
l'équipement de génération d'horloge (25) est une source de lumière pulsée avec la fréquence d'horloge, en particulier un laser pulsé ou une diode laser pulsée ou une diode pulsée, et/ou
l'élément de conversion (30-37, 73a, 73b) est respectivement une photodiode ou un phototransistor.

5. Dispositif optoélectronique selon l'une des revendications 1 à 4,
**caractérisé en ce que**
le dispositif optoélectronique (1, 3) est un circuit d'échantilionnage,
les durées d'exécution des circuits optoélectroniques (2, 4a, 4b) sont dimensionnées de telle sorte que des moments d'échantillonnage différents des organes échantillonneurs-bloqueurs (40-47, 74a, 74b) se produisent pour des diviseurs entiers de chaque période d'horloge, et
l'équipement de régulation (78a, 78b) est conçu pour ajuster les moments d'échantillonnage par réglage des durées d'exécution des circuits optoélectroniques (2, 4a, 4b).

6. Dispositif optoélectronique selon l'une des revendications 1 à 5,
**caractérisé en ce que**
le dispositif optoélectronique est un circuit multiplexeur,
le dispositif optoélectronique dispose d'organes de commutation sous la forme des composants électroniques auxquels les circuits optoélectroniques (2, 4a, 4b) transmettent le signal d'horloge,
les durées d'exécution des circuits optoélectroniques (2, 4a, 4b) sont dimensionnées de telle sorte que des moments de commutation différents des organes de commutation se produisent pour des diviseurs entiers de chaque période d'horloge, et
l'équipement de régulation (78a, 78b) est conçu pour ajuster les moments de commutation par réglage des durées d'exécution des circuits optoélectroniques (2, 4a, 4b).

7. Dispositif optoélectronique selon l'une des revendications 1 à 6,
**caractérisé en ce que**
l'équipement de régulation (78a, 78b) est conçu pour compenser un gradient de température (62) à l'intérieur du dispositif optoélectronique au moyen des éléments optiques réglables.

8. Procédé de transmission d'un signal d'horloge optique à un composant électronique (40-47, 74a, 74bavec les étapes suivantes :
- génération du signal d'horloge optique,
- conversion du signal d'horloge optique en un signal d'horloge électrique amené au composant électronique (40-47, 74a, 74b),
- amenée du signal d'horloge optique via une liaison optique (60, 72a, 72b) vers la conversion en le signal d'horloge électrique,
dans lequel le signal d'horloge présente une durée d'exécution allant de la génération d'horloge jusqu'au composant électronique (40-47, 74a, 74b),
dans lequel la durée d'exécution est réglée et régulée,
**caractérisé en ce que**
les composants électroniques (40-47, 74a, 74b) vers lesquels le signal d'horloge est transmis sont des organes échantillonneurs-bloqueurs, et
dans le cadre d'une mesure de calibrage, des valeurs de calibrage sont déterminées sur la base d'un signal de calibrage introduit dans les organes échantillonneurs-bloqueurs, et les durées d'exécution sont réglées sur la base des valeurs de calibrage.

9. Procédé selon la revendication 8,
**caractérisé en ce que**
la durée d'exécution est réglée par modification d'une longueur optique d'une liaison optique (60, 72a, 72b),
la longueur optique de la liaison optique (60, 72a, 72b) est réglée pour le réglage de la durée d'exécution par chauffage de la liaison optique (60, 72a, 72b).

10. Procédé selon la revendication 9,
**caractérisé en ce que**
la durée d'exécution est réglée par réglage de la longueur optique d'une cellule de Kerr ou d'une cellule de Pockels, laquelle est connectée en série par rapport à une liaison optique, par application d'un signal électrique à la cellule de Kerr ou à la cellule de Pockels.

11. Procédé selon l'une des revendications 8 à 10,
**caractérisé en ce que**
le procédé sert à la transmission d'un signal d'horloge dans un circuit d'échantilionnage,
les durées d'exécution sont dimensionnées de telle sorte que des moments d'échantillonnage différents des organes échantillonneurs-bloqueurs (40-47, 74a, 74b) se produisent pour des diviseurs entiers de chaque période d'horloge, et
les moments d'échantillonnage sont ajustés par réglage des durées d'exécution des circuits optoélectroniques (2, 4a, 4b).

12. Procédé selon l'une des revendications 8 à 11,
**caractérisé en ce que**
le procédé sert à la transmission d'un signal d'horloge dans un circuit multiplexeur,
les composants électroniques auxquels le signal d'horloge est transmis sont des organes de commutation,
les durées d'exécution sont dimensionnées de telle sorte que des moments de commutation différents des organes de commutation se produisent pour des diviseurs entiers de chaque période d'horloge, et
les moments de commutation sont ajustés par réglage des durées d'exécution.

13. Procédé selon l'une des revendications 8 à 12,
**caractérisé en ce que**
un gradient de température (62) est compensé.
